Europäisches Patentamt

European Patent Office

Office européen des brevets

(19)

(11) **EP 0 923 179 A2**

(12) **EUROPÄISCHE PATENTANMELDUNG**

(43) Veröffentlichungstag:
16.06.1999 Patentblatt 1999/24

(51) Int. Cl.$^6$: **H02H 3/12**, H03K 17/18

(21) Anmeldenummer: 98122516.2

(22) Anmeldetag: 27.11.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **10.12.1997 DE 19754927**

(71) Anmelder:
**SIEMENS AKTIENGESELLSCHAFT**
**80333 München (DE)**

(72) Erfinder: **Zitta, Heinz**
**9580 Drobollach (AT)**

(54) **Schaltungsanordnung zur Leerlauferfassung**

(57)     Die Erfindung betrifft eine Schaltungsanordnung Schaltungsanordnung zur Leerlauferfassung von mindestens einem über ein getaktetes Ansteuersignal ansteuerbaren Leistungsschalter, dessen Laststrecke in Reihe geschaltet ist zu einer Strommeßeinrichtung. Am Ausgang der Strommeßeinrichtung ist ein Diagnosesignal abgreifbar, das anzeigt, ob der Leistungsschalter geöffnet oder geschlossen ist. Zusätzlich ist der Strommeßeinrichtung eine Diagnoselogikschaltung nachgeschaltet. Die Diagnoselogikschaltung erzeugt ein Freigabesignal, das im eingeschwungenen Zustand auch in den Taktpausen des Ansteuersignals einen ersten Wert aufweist und im nicht eingeschwungenen Zustand oder bei einer Taktunterbrechung des Ansteuersignals einen zweiten Wert aufweist. Auf diese Weise ist es möglich, einen Fehlerfall, der eine Unterbrechung des Laststromes zur Folge hat, von dem Fall, daß der Leistungsschalters in den Taktpausen des getakteten Ansteuersignals ausgeschaltet ist, unterscheiden zu können.

**FIG 2**

EP 0 923 179 A2

**Beschreibung**

Die Erfindung betrifft eine Schaltungsanordnung zur Leerlauferfassung von mindestens einem über ein getaktetes Ansteuersignal ansteuerbaren Leistungsschalter

Bekannte Schaltungsanordnung zur Erkennung eines Leerlaufes eines Leistungsschalters messen den Laststrom und geben nur dann ein Freigabesignal aus, wenn eine vorgegebene Leerlaufstromschwelle überschritten wird. Wird jedoch der getaktete Leistungsschalter mit einem getaktetem Laststrom angesteuert, dann ist im Diagnosesignal die Frequenz des Ansteuersignals sichtbar.

Ein gattungsgemäßes Diagnosesystem zur Leerlauferkennung eines Leistungsschalters ist beispielsweise aus Jens Peer Stengl, Jenö Tihanyi, Leistungs-MOS-FET-Praxis,  Pflaum-Verlag  München, 1992, Seiten 118 bis 125, bekannt.

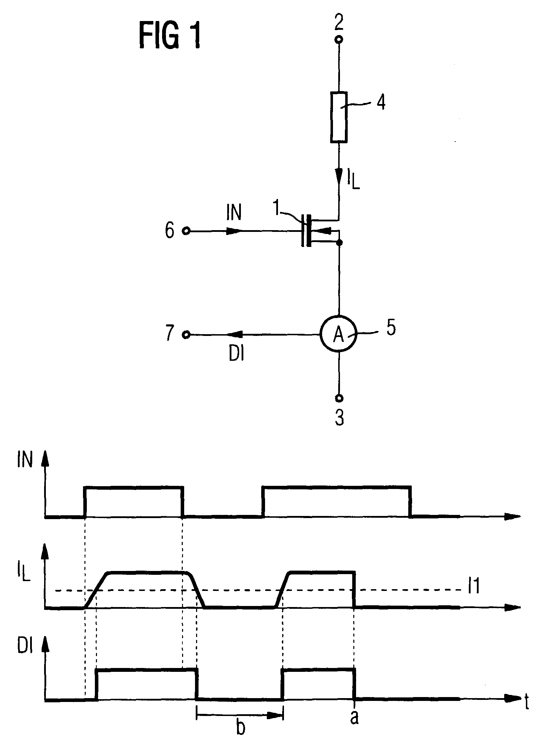

Figur 1 der Zeichnung zeigt einen derartigen Leistungsschalter mit einer Strommessung als Diagnosefunktion nach dem Stand der Technik, bei dem zusätzlich das zugehörige Impulszeitdiagramm angegeben ist.

In Figur 1 ist mit 1 ein Leistungsschalter bezeichnet. Im vorliegenden Fall ist der Leistungsschalter ein n-Kanal-Depletion-MOSFET. Der Leistungsschalter 1 ist mit seiner Laststrecke zwischen einem ersten und zweiten Pol einer Versorgungsspannungsquelle 2, 3 geschaltet. Dabei kann der erste Pol der Ver-sorgungsspannungsquelle  2  beispielsweise  ein Versorgungpotential sein, während der zweite Pol der Versorgungsspannungsquelle 3 beispielsweise die Bezugsmasse sein kann. Im Fall des vorliegenden Ausführungsbeispiels ist der Leistungsschalter 1 als Low-Side-Schalter ausgebildet, bei dem eine zu schaltende Last 4 zwischen dem Drainanschluß des Leistungsschalters 1 und dem positiven Pol der Versorgungsspannungsquelle  angeordnet  ist.  Zwischen  dem Sourceanschluß des Leistungsschalters 1 und dem Anschluß für die Bezugsmasse 3 ist eine Strommeßeinrichtung 5 geschaltet.

Am Logikeingang 6 wird ein Aristeuersignal IN eingekoppelt. Der Gateanschluß des Leistungsschalters 1 wird dann über das Ansteuersignal IN angesteuert. Ein High-Signal schaltet bei Überschreiten einer vorgegebenen Laststromschaltschwelle I1 den Leistungsschalter 1 ein und ein Laststrom IL kann vom ersten Pol 2 zum zweiten Pol 3 der Versorgungsspannungsquelle fließen. Über die Strommeßeinrichtung 5 kann der Laststrom IL gemessen werden. Die Strommeßeinrichtung 5 erzeugt ein Diagnosesignal DI, das am Logikausgang 7 der Schaltungsanordnung abgreifbar ist. Es wird somit als Diagnosesignal DI immer dann ein High-Signal ausgegeben, wenn der Laststrom IL eine vorgegebene Schwelle I1 überschreitet.

Zum Zeitpunkt a wird im vorliegenden Beispiel eine Stromunterbrechung durch einen Fehler angenommen. Dieser Fehler wird am Logikausgang 7 durch ein Low-Signal des Diagnosesignals DI angezeigt. Im Zeitraum b ist aufgrund der Taktpause des getakteten Ansteuersignals IN das Diagnosesignal DI ebenfalls Low. Der Leistungsschalter 1 ist abgeschaltet und somit kann auch kein Laststrom IL fließen.

Interpretiert man die zwei High-Phasen des Ansteuersignals IN jedoch als einen Ausschnitt einer getakteten Ansteuerung, so besteht hier der Bedarf, den Fehlerfall a vom Fall b, in dem sich die Schaltungsanordnung im normalen Taktbetrieb befindet, unterscheiden zu können.

Ausgehend von diesem Stand der Technik liegt daher  der  vorliegenden  Erfindung  die  Aufgabe zugrunde, eine gattungsgemäße Schaltungsanordnung zur Erfassung eines Leerlaufes einer Leistungsendstufe zu realisieren, die den genannten Fehlerfall von dem getakteten Betriebsfall unterscheiden kann und ein Freigabesignal auch dann erzeugt, wenn der Laststrom durch die getaktete Ansteuerung periodisch unterbrochen ist.

Erfindungsgemäß wird diese Aufgabe durch eine Schaltungsanordnung zur Leerlauferfassung mit den Merkmalen des Patentanspruchs 1 gelöst.

Durch die erfindungsgemäße Schaltungsanordnung zur Leerlauferkennung wird auch dann ein Diagnosesignal geliefert, wenn der Laststrom aufgrund der getakteten Ansteuerung des Leistungsschalters periodisch unterbrochen wird. Auf diese Weise ist es möglich, einen Fehlerfall, der eine Unterbrechung des Laststromes zur Folge hat, von dem durch die Taktpausen des getakteten Ahsteuersignals ausgeschalteten Leistungsschalters unterscheiden zu können.

Die Diagnoselogikschaltung weist dabei typischerweise eine Signalverzögerungseinrichtung und eine Speichereinrichtung auf.

Durch die Signalverzögerungseinrichtung wird das getaktete Ansteuersignal in dessen Taktpausen derart verzögert, daß bei dem ausgangsseitig an der Signalverzögerungseinrichtung abgreifbaren verzögerten Ahsteuersignal bereits die Taktpausen des Ansteuersignals unterdrückt sind. Es stellt somit einen zusammenhängenden Puls je Ansteuerzyklus dar.

Um dieser Anforderung genüge zu leisten, muß die Verzögerungsdauer durch die erste Verzögerungseinrichtung mindestens so groß sein wie der Reziprokwert  der  kleinsten  Taktfrequenz  des Ansteuersignals.

Als Speichereinrichtung dient typischerweise ein Flip-Flop. Besonders vorteilhaft ist es, wenn das Flip-Flop als RS-Flip-Flop ausgebildet ist. In dessen Eingänge werden die über jeweils ein logisches Gatter verknüpften Ansteuersignale und Diagnosesignale eingekoppelt.

Typischerweise ist eine weitere Signalverzögerungseinrichtung vorgesehen, die der Einschaltdauer des Leistungsschalters, d.h. bis der Laststrom eine vor-gegebene Laststromschaltschwelle erreicht hat, Rech-

nung trägt. Die weitere Signalverzögerungseinrichtung verzögert dabei typischerweise das Ausgangssignal der Speichereinrichtung um eine zweite Zeitdauer, die üblicherweise sehr viel kleiner ist als die erste Zeitdauer. Sie beträgt typischerweise einige Mikrosekunden.

Die Leistungsendstufe weist typischerweise eine zu schaltende Last auf, die in Reihe zur Laststrecke des Leistungsschalters angeordnet ist. Die zu schaltende Last kann dabei einen Widerstand, eine Induktivität, oder ähnliches enthalten.

Besonders vorteilhaft ist es, wenn der Leistungsschalter als MOSFET ausgebildet ist. Es wäre jedoch auch möglich, den Leistungsschalter als Bipolartransistor, IGBT, Thyristor, oder ähnliches zu realisieren.

In einer vorteilhaften Ausgestaltung ist die zu schaltende Last zwischen einem positiven Pol der Versorgungsspannungsquelle und dem Leistungsschalter angeordnet. In diesem Fall ist die Leistungsendstufe als Low-Side-Schalter realisiert.

Besonders vorteilhaft ist die Erfindung, wenn die Leistungsendstufe als Motorstrombrücke ausgebildet ist. Ein Unterbrechen des Laststromes muß hier sofort und zuverlässig diagnostiziert werden, damit der nachgeschaltete elektrische Antrieb nicht im Leerlauf betrieben wird.

Eine besonders vorteilhafte Verwendung findet die Erfindung in einem Schaltnetzteil.

Vorteilhafte Ausgestaltungen und Weiterbildungen sind Gegenstand der Unteransprüche.

Nachfolgend wird die Erfindung anhand der in den Figuren der Zeichnung dargestellten Ausführungsbeispiele näher erläutert. Es zeigt dabei:

Figur 1    eine Schaltungsanordnung zur Erfassung des Leerlaufs und dem dazugehörigen Impulszeitdiagramm nach dem Stand der Technik;

Figur 2    eine erfindungsgemäße Schaltungsanordnung zur Erfassung des Leerlaufs eines Leistungsschalters mit Diagnoselogikschaltung;

Figur 3    ein Ausführungsbeispiel für die erfindungsgemäße Diagnoselogikschaltung entsprechend Figur 2 mit zugehörigem Impulszeitdiagramm;

Figur 4    ein weiteres Ausführungsbeispiel einer erfindungsgemäßen Schaltungsanordnung zur Erfassung des Leerlaufs mit zugehörigem Impulszeitdiagramm.

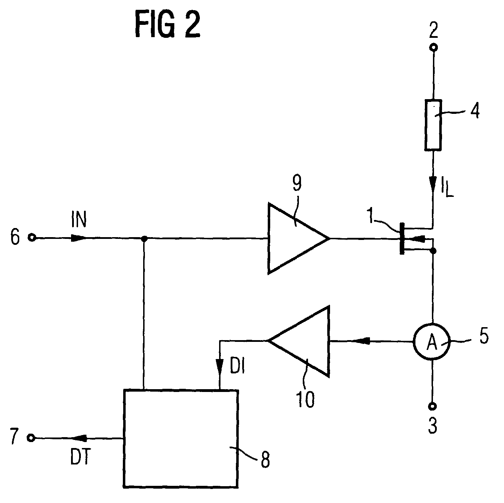

Figur 2 zeigt eine erfindungsgemäße Schaltungsanordnung zur Erfassung eines Leerlaufs einer zu schaltenden Last 4. Gleiche bzw. funktionsgleiche Elemente sind entsprechend Figur 1 mit gleichen Bezugszeichen versehen.

Die in Figur 2 gezeigte Schaltungsanordnung ist gegenüber der in Figur 1 gezeigten Schaltungsanordnung derart weitergebildet, daß eine Diagnoselogikschaltung 8 vorgesehen ist. Die Diagnoselogikschaltung 8 ist hier der Strommeßeinrichtung 5 nachgeschaltet. Am Eingang der Diagnoselogikschaltung 8 wird zum einen das getaktete Ansteuersignal IN und zum anderen das Diagnosesignal DI, welches ausgangsseitig von der Strommeßeinrichtung 5 erzeugt wird, eingekoppelt. Die Diagnoselogikschaltung 8 erzeugt ein Freigabesignal DT, das am Logikausgang 7 der Schaltungsanordnung abgreifbar ist.

Zusätzlich können, wie in Figur 2 gezeigt, Verstärkereinrichtungen 9, 10 vorgesehen sein. Im vorliegenden Fall ist eine erste Verstärkereinrichtung 9 dem Gateanschluß des Leistungsschalters 1 vorgeschaltet. Eine zweite Verstärkereinrichtung 10 verstärkt das ausgangsseitig von der Strommeßeinrichtung 5 erzeugte Diagnosesignal DI.

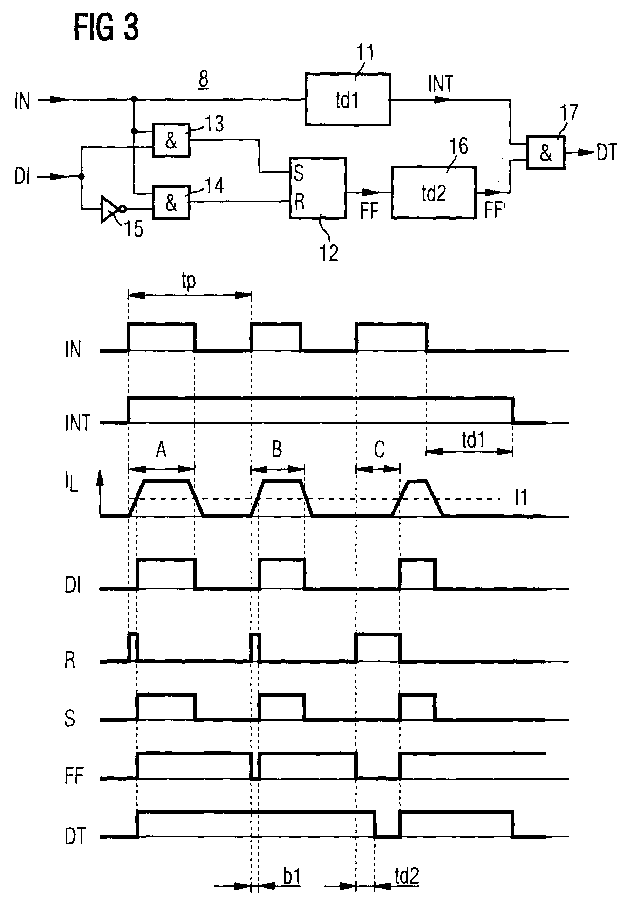

Figur 3 zeigt ein konkretes Ausführungsbeispiel der Diagnoselogikschaltung 8 entsprechend Figur 2. Zusätzlich ist in Figur 3 das zugehörige Impulszeitdiagramm angegeben. Gleiche bzw. funktionsgleiche Elemente sind entsprechend den Figuren 1 und 2 mit gleichen Bezugszeichen versehen.

Die Diagnoselogikschaltung 8 in Figur 3 enthält eine erste Verzögerungseinrichtung 11. Am Eingang der ersten Verzögerungseinrichtung 11 wird das Ansteuersignal IN eingekoppelt. Am Ausgang der ersten Verzögerungseinrichtung 11 ist dann das Ausgabesignal INT der ersten Verzögerungseinrichtung 11 abgreifbar.

Des weiteren weist die Diagnoselogikschaltung 8 eine Speichereinrichtung 12 auf. Im vorliegenden Fall ist die Speichereinrichtung 12 ein RS-Flip-Flop. Die Speichereinrichtung 12 kann jedoch auch durch ein gängiges anderes Flip-Flop oder ein Latch bzw. durch jede andere Schaltungsanordnung mit Speicherfunktion realisiert werden. Die als RS-Flip-Flop ausgebildete Speichereinrichtung 12 weist einen Set-Eingang S und Reset-Eingang R auf.

Das Ansteuersignal IN und das Diagnosesignal DI werden in ein erstes UND-Gatter 13 eingekoppelt. Das Ausgangssignal des ersten UND-Gatters 13 wird in den Set-Eingang S der Speichereinrichtung 12 eingekoppelt. Das Ansteuersignal IN und das invertierte Diagnosesignal DI werden in ein zweites UND-Gatter 14 eingekoppelt. Die Invertierung erfolgt hier über einen Inverter 15, der dem zweiten UND-Gatter 14 vorgeschaltet ist. Das Ausgangssignal des zweiten UND-Gatters 14 wird in den Reset-Eingang R der Speichereinrichtung 12 eingekoppelt.

Am Ausgang der Speichereinrichtung 12 ist ein Speicherausgangssignal FF abgreifbar. Der Speichereinrichtung 12 ist eine zweite Verzögerungseinrichtung 16 nachgeschaltet, in die das Speicherausgangssignal FF eingekoppelt wird. Am Ausgang der zweiten Verzögerungseinrichtung 16 ist ein verzögertes Speicherausgangssignal FF' abgreifbar. Das verzögerte Speicherausgangssignal FF' wird zusammen mit dem verzögerten Ansteuersignal INT in ein drittes UND-Gatter 17 eingekoppelt. Am Ausgang des dritten UND-Gatters 17 ist dann das Freigabesignal DT abgreifbar.

Die in den Figuren 2 und 3 angegebene Schaltungsanordnung hebt sich von der Schaltungsanordnung entsprechend Figur 1 dadurch ab, daß hier die Taktpausen der getakteten Ansteuerung von einer Fehlermeldung in Folge einer echten Stromunterbrechung des Laststromes IL unterschieden werden können.

Die erste Verzögerungseinrichtung 11 weist dabei eine Verzögerung des Ansteuersignals IN in desen Taktpause um eine erste Verzögerungsdauer td1 auf. Das daraus resultierende verzögerte Ausgangssignal INT weist somit in den dem High-Signal des getakteten Ansteuersignals IN nachfolgenden Taktpausen ebenfalls ein High-Signal mit der Signaldauer td1 auf. Dabei wird die positive Flanke des getakteten Ansteuersignals IN durch die Verzögerungseinrichtung 11 jeweils um die Verzögerungszeit td1 verlängert. Die Verzögerungszeit td1 ist dabei so zu wählen, daß sie mindestens so groß ist wie die minimale Takfrequenz des getakteten Ansteuersignals IN. Sie muß somit die Bedingung

$$td1 \geq 1/f_{min}$$

erfüllen. Hier ist $f_{min}$ die niedrigste praktisch vorkommende Frequenz für des Ansteuersignals IN. Typischerweise ist jedoch die Frequenz des getakteten Ansteuersignals IN konstant. Allerdings wäre es auch möglich, daß die Frequenz des getakteten Ansteuersignals IN, wie beispielsweise bei der pulsweitenmodulierten Ansteuerung einer Last, variabel ist. In diesem Fall ist die obige Gleichung Ungleichung relevant.

Das verzögerte Ansteuersignal INT unterdrückt damit bereits die Taktpausen des Ansteuersignals IN und stellt somit einen zusammenhängenden Puls je Ansteuerzyklus dar.

Im Diagnosesignal DI sind jedoch noch die Taktpausen des Ansteuersignals IN abgebildet: Das Diagnosesignal ist High, wenn der Laststrom IL die vorgegebene Laststromschwelle I1 überschreitet. Im anderen Fall ist das Diagnosesignal Low.

Durch die logische Verknüpfung des Ansteuersignals IN und des Diagnosesignals DI im ersten UND-Gatter 13 wird ein Set-Signal erzeugt. Durch die logische Verknüpfung des Ansteuersignals IN und des invertierten Diagnosesignals DI im zweiten UND-Gatter 14 wird ein Reset-Signal erzeugt. Durch das Set-Signal und Reset-Signal wird das RS-Flip-Flop 12 gesetzt bzw. zurückgesetzt. Am Ausgang des RS-Flip-Flops 12 ist das Speicherausgangssignal FF abgreifbar. Das Speicherausgangssignal FF bildet dabei im wesentlichen die Signalform des verzögerten Ansteuersignals INT ab. Zusätzlich ist im Speicherausgangssignal FF die Zeitdauer b1, die der Laststrom IL bis zum Erreichen der vorgegebene Schaltschwelle I1 benötigt, abgebildet.

In den Kurvenformen des Laststromes IL ist in den Phasen A und B Normalbetrieb ohne Fehler angenommen. In der Zeitdauer C sei ein Fehler beispielsweise durch eine Stromunterbrechung des Laststromes IL aufgetreten. Durch die genannte Dauer der Einschaltflanke b1 des Laststromes IL wird jedoch noch bei jedem Einschalten für eine kurze Zeitdauer die Fehlermeldung „kein Laststrom", welches im Speicherausgangssignal FF während der Dauer der Einschaltflanke b1 sichtbar wird, erzeugt.

Durch die zweite Verzögerungseinrichtung 16 werden nun diese kurzen Einschaltimpulse, die durch die Einschaltflanken bewirkt werden, unterdrückt. Am Ausgang der Verzögerungseinrichtung 16 ist dann ein verzögertes Speicherausgangssignal FF' abgreifbar.

Die zweite Verzögerungszeit td2 der zweiten Verzögerungseinrichtung 16 ist typischerweise sehr viel kleiner als die erste Verzögerungszeit td1, da sie lediglich die Schaltzeit des Leistungsschalters 1 bzw der Leistungsendstufe überbrücken muß. Somit ist die zweite Verzögerungszeit td2 mindestens so groß wie die Dauer der Einschaltflanke des Leistungsschalters 1 zu wählen. Im allgemeinen weist die zweite Verzögerungszeit td2 Werte von einigen Mikrosekunden auf.

Das verzögerte Speicherausgangssignal FF' sowie das verzögerte Ansteuersignal INT werden in dem dritten UND-Gatter 17 logisch verknüpft. An dessen Ausgang ist das Freigabesignal DT abgreifbar.

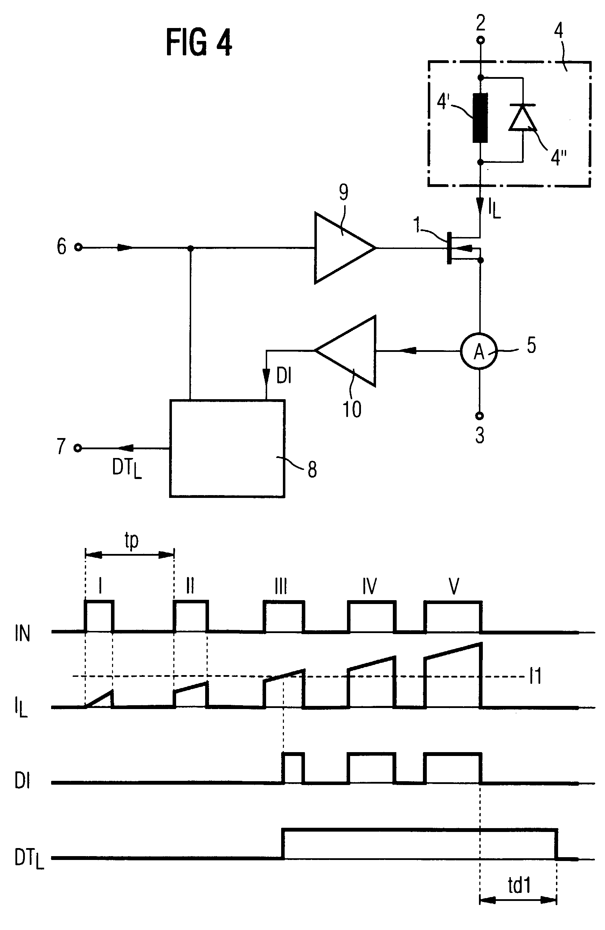

Figur 4 zeigt ein weiteres Ausführungsbeispiel einer Schaltungsanordnung eines Leistungsschalters mit Strommeßeinrichtung und erfindungsgemäßer Diagnoselogikschaltung 8. Gleiche bzw. funktionsgleiche Elemente sind hier entsprechend den vorhergehenden Figuren mit gleichen Bezugszeichen versehen.

In Figur 4 ist die zu schaltende Last 4 als Induktivität 4' ausgebildet. Parallel zur Induktivität 4' ist dabei eine Freilaufdiode 4" angeordnet. Durch die Induktivität 4' steigt der Laststrom IL nur langsam an. In den ersten beiden Takten I, II des Ansteuersignals IN erreicht der Laststrom IL nicht die Laststromschaltschwelle I1. Das Diagnosesignal DI bleibt in den ersten beiden Takten I, II auf Low.

Im dritten Takt III wird erstmals die Laststromschaltschwelle I1 überschritten. In den Ansteuerpausen ist der Strom im Meßpfad 0, jedoch fließt tatsächlich der Strom weiterhin durch die Freilaufdiode 4". Das Diagnosesignal DI spiegelt diesen Sachverhalt in einer Unterbrechung des Diagnosesignals DI im Taktrhythmus des Ansteuersignals IN an, obwohl tatsächlich jetzt weder ein Fehler vorliegt, noch der Laststrom IL im eingeschalteten Zustand die Laststromschwelle I1 nicht unterschritten hat. Am Logikausgang 7 der Schaltungsanordnung wird ab Takt III das gewünschte Freigabesignal $DT_L$ ausgegeben.

Die beschriebene Diagnoselogikschaltung 8 eignet sich somit sehr gut bei der getakteten Ansteuerung einer induktiven Last 4' insbesondere mit parallel geschalteter mit Freilaufdiode 4".

In den Ausführungsbeispielen in den Figuren 2 und 4 liegt der erste Pol 2 auf dem Potential der Versorgungsspannungsquelle und der zweite Pol auf dem Potential der Bezugsmasse. In diesem Fall ist der Leistungsschalter 1 als Low-Side-Schaltern ausgebildet. Die erfindungsgemäße Schaltungsanordnung zur Erfassung eines Leerlaufes eignet sich jedoch bei allen Arten einer Leistungsendstufe, wie beispielsweise High-Side-Schaltern, Brückenschaltungen, Tri-State-Schaltungen, etc. eingesetzt werden. Die Ansteuerung muß dabei nicht notwendigerweise ein getaktetes Ansteuersignal sein, sondern kann auch ein kontinuierliches Signal sein.

Besonders vorteilhaft ist die Erfindung bei Verwendung in einem Schaltnetzteil.

## Patentansprüche

1.    Schaltungsanordnung zur Leerlauferfassung von mindestens einem über ein getaktetes Ansteuersignal (IN) ansteuerbaren Leistungsschalter (1), dessen Laststrecke in Reihe geschaltet ist zu einer Strommeßeinrichtung (5), wobei am Ausgang der Strommeßeinrichtung (5) ein Diagnosesignal (DI) abgreifbar ist, das angibt, ob der Laststrom durch den Leistungsschalter eine vorgegebene Schwelle überschreitet oder nicht, und der Strommeßeinrichtung (5) eine Diagnoselogikschaltung (8) nachgeschaltet ist, an deren Ausgang ein Freigabesignal (DT) abgreifbar ist, wobei das Freigabesignal (DT)

   • im eingeschwungenen Zustand auch in den Taktpausen des Ansteuersignals (IN) einen ersten Wert aufweist und
   • im nicht eingeschwungenen Zustand oder bei einer Taktunterbrechung des Ansteuersignals (IN) einen zweiten Wert aufweist.

2.    Schaltungsanordnung nach Anspruch 1,
   **dadurch gekennzeichnet,**
   daß die Diagnoselogikschaltung (8) mindestens eine erste Signalverzögerungseinrichtung (11) und mindestens eine Speichereinrichtung (12) aufweist.

3.    Schaltungsanordnung nach Anspruch 2,
   **dadurch gekennzeichnet,**
   daß die erste Signalverzögerungseinrichtung (11) das Ansteuersignal (IN) in dessen Taktpausen um eine erste Zeitdauer (td1) verzögert.

4.    Schaltungsanordnung nach einem der Ansprüche 2 oder 3,
   **dadurch gekennzeichnet,**
   daß die erste Zeitdauer (td1) mindestens so groß ist wie der reziproke Wert der kleinsten Taktfrequenz (fmin) des Ansteuersignals (IN).

5.    Schaltungsanordnung nach einem der Ansprüche 2 bis 4,
   **dadurch gekennzeichnet,**
   daß das über ein erstes logisches UND-Gatter (13) verknüpfte Ansteuersignal (IN) und Diagnosesignal (DI) in den ersten Eingang (S) der Speichereinrichtung (12) eingekoppelt wird und das über ein zweites logisches UND-Gatter (14) verknüpfte Ansteuersignal (IN) und invertierte Diagnosesignal (DI) in den zweiten Eingang (R) der Speichereinrichtung (8) eingekoppelt wird.

6.    Schaltungsanordnung nach einem der Ansprüche 2 bis 5,
   **dadurch gekennzeichnet,**
   daß die Speichereinrichtung (12) ein RS-Flip-Flop ist.

7.    Schaltungsanordnung nach einem der Ansprüche 2 bis 6,
   **dadurch gekennzeichnet,**
   daß eine zweite Signalverzögerungseinrichtung (11) vorgesehen ist, die ein Ausgangssignal (FF) der Speichereinrichtung (8) in dessen Taktpausen um eine zweite Zeitdauer (td2) verzögert, wobei die zweite Zeitdauer (td2) mindestens so groß ist wie die Dauer eines Einschaltvorganges bis das Ansteuersignal (IN) eine vorgegebene Schaltschwelle (I1) erreicht hat.

8.    Schaltungsanordnung nach einem der vorhergehenden Ansprüche,
   **dadurch gekennzeichnet,**
   daß zwischen dem ersten Pol (2) und dem zweiten Pol (3) der Versorgungsspannungsquelle mindestens eine zu schaltende Last (4) in Reihe zur Laststrecke des Leistungsschalters (1) angeordnet ist.

9.    Schaltungsanordnung nach Anspruch 8,
   **dadurch gekennzeichnet,**
   daß die zu schaltende Last (4) eine Induktivität (4') aufweist.

10.    Schaltungsanordnung nach einem der vorhergehenden Ansprüche,
   **dadurch gekennzeichnet,**
   daß der Leistungsschalter (1) ein MOSFET ist.

11.    Schaltungsanordnung nach einem der vorhergehenden Ansprüche,
   **dadurch gekennzeichnet,**
   daß die Leistungsendstufe einen Low-Side-Schalter enthält.

12.    Schaltungsanordnung nach einem der vorhergehenden Ansprüche,
**dadurch gekennzeichnet**,
daß die Leistungsendstufe eine Motorstrombrücke
enthält.

13. Verwendung einer Schaltungsanordnung zur Erfassung eines Leerlaufs einer Leistungsschaltung (1) nach einem der vorhergehenden Ansprüche in einem Schaltnetzteil.

# FIG 1

FIG 2

# FIG 3

# FIG 4